# EUROPÄISCHE PATENTANMELDUNG

(11) **EP 1 160 045 A2**
(43) Veröffentlichungstag der Anmeldung: **05.12.2001**
(21) Anmeldenummer: 01109992.6
(22) Anmeldetag: 25.04.2001
(51) Int. Cl.: B23K 26/06, H05K 3/02

(54) **Vorrichtung und Verfahren zur Beschriftung von kupferkaschierten Laminaten**

(30) Priorität: 27.05.2000 DE 10026499
(71) Anmelder: Isola AG, 52353 Düren (DE)
(72) Erfinder: Kenn, Christoph, Dipl.-Ing., 52351 Düren (DE); Schumacher, Theo, 52353 Düren (DE)
(74) Vertreter: TER MEER STEINMEISTER & PARTNER GbR

(57) **Zusammenfassung**

Eine Vorrichtung zur Beschriftung von kupferkaschierten Laminaten umfaßt einen Laser (10), in dessen Resonator (12) eine Blende (24) zur Intensitätssteuerung angeordnet ist, eine Aufweitungsoptik (26) zum Aufweiten des Laserstrahls (18) und eine Fokussierungsoptik (30) zum Fokussieren des aufgeweiteten Laserstrahls (28) auf der Oberfläche eines Werkstücks (32) aus kupferkaschiertem Laminat. Bei einem entsprechenden Verfahren zum Beschriften von kupferkaschierten Laminaten wird ein Laserstrahl (18) aufgeweitet und der aufgeweitete Laserstrahl (28) auf die Oberfläche eines Werkstücks (32) aus kupferkaschiertem Laminat fokussiert, wobei die Laserintensität innerhalb des Laserresonators (12) durch eine Blende (24) gesteuert wird.

## Beschreibung

Die vorliegende Erfindung betrifft eine Vorrichtung und ein Verfahren zur Beschriftung von kupferkaschierten Laminaten.

Kupferkaschierte Laminate werden als Basismaterial zur Leiterplattenfertigung verwendet. Es handelt sich dabei um elektrisch hochisolierende Schichtpreßstoffe, die mit einer Kupferkaschierung, also einer Kupferbeschichtung versehen sind. Die Zwischenschicht besteht in der Regel aus einem Glashartgewebe mit einer Harzmatrix, die beispielsweise aus Epoxidharz besteht. Ferner ist es möglich, die Zwischenschicht beispielsweise aus einem Glasvlies, einem Aramidgewebe oder- vlies oder auch aus einem Phenolharzhartpapier herzustellen.

Ein Werkstück aus kupferkaschiertem Laminat wird in bekannter Weise zu einer Leiterplattenschaltung verarbeitet, indem Teile der Kupferschicht weggeätzt werden, so daß die verbleibenden Kupferflächen das gewünschte Leiterbild auf der isolierenden Zwischenschicht darstellen.

Es ist erwünscht, die Werkstücke vor der Verarbeitung zu beschriften, so daß eine eindeutige Identifizierung möglich ist. Zu diesem Zweck ist es üblich, in die Werkstücke an einer Stelle, die bei der oben beschriebenen Herstellung der Schaltung nicht bearbeitet wird, durch Stanzen einen Schriftzug zu prägen. Dabei wird das Kupferlaminat jedoch dauerhaft mechanisch verformt. Diese Verformung, die beispielsweise an einer beschrifteten Ecke des Werkstücks auftritt, ist jedoch bei der Weiterverarbeitung höchst unerwünscht. Darüber hinaus muß zum Ändern des Schriftzuges eine relativ lange Umrüstzeit der Prägevorrichtung in Kauf genommen werden. Außerdem ist es problematisch, das Prägen so durchzuführen, daß der eingeprägte Schriftzug auch nach dem Abätzen der Kupferschicht auf der Zwischenschicht lesbar bleibt.

Aufgabe der Erfindung ist es daher, ein Verfahren sowie eine Vorrichtung zur Beschriftung von kupferkaschierten Laminaten zu schaffen, die die zuvor beschriebenen Nachteile überwindet.

Diese Aufgabe wird erfindungsgemäß durch eine Vorrichtung gemäß Anspruch 1 sowie ein Verfahren gemäß Anspruch 9 gelöst.

Die erfindungsgemäße Vorrichtung ist mit einem Laser ausgestattet, in dessen Resonator eine Blende angeordnet ist, durch die sich die Intensität des erzeugten Laserstrahls steuern läßt. Der aus dem Resonator austretende Laserstrahl wird durch eine Aufweitungsoptik wie beispielsweise eine Streulinse zunächst aufgeweitet und anschließend durch eine Fokussierungsoptik wie etwa eine Sammellinse auf die Oberfläche des zu beschriftenden Werkstücks aus kupferkaschiertem Laminat fokussiert.

Im Brennpunkt der Sammellinse wird die Kupferoberfläche des Laminats durch den Laserstrahl erhitzt und verdampft, so daß die Zwischenschicht des Lamiinats freigelegt wird. Die Oberfläche des Epoxidmaterials der Zwischenschicht wird durch die Hitze karbonisiert, d. h., es werden Kohlenstoffverbindungen an der Oberfläche erzeugt, so daß diese geschwärzt wird.

Für diesen Prozeß ist eine sehr hohe Laserintensität notwendig, da Kupfer sehr stark wärmeleitend ist und die notwendigen Temperaturen im Brennpunkt nur schwer zu erreichen sind. Aus diesem Grund ist es notwendig, einen sehr kleinen Brennpunkt zu erzeugen. Dies ist der Grund, warum vor dem Fokussieren der Laserstrahl zunächst aufgeweitet wird. Beispielsweise wird durch eine Aufweitung etwa um den Faktor 6 ein Fokusdurchmesser von weniger als 50 µm erreicht. Andererseits muß die Laserintensität geeignet dosiert werden, damit nicht außer der obersten Kupferschicht auch die Zwischenschicht durchbrannt wird. Dazu dient die im Resonator angeordnete Blende. Durch Einstellen der Größe der Blende läßt sich die Intensität des erzeugten Laserstrahls sehr genau dosieren.

Durch Abtasten des Werkstücks mit dem Laser läßt sich somit die gewünschte Beschriftung erzeugen. Dazu werden zweckmäßigerweise die optischen Bestandteile der Vorrichtung zu einem Abtastkopf zusammengefaßt, der sich über die Werkstückoberfläche hinweg bewegt.

Die erfindungsgemäße Vorrichtung bietet den Vorteil, daß das Werkstück bei der Beschriftung nicht verformt wird und in dieser Hinsicht bei der weiteren Verarbeitung keine Probleme auftreten. Ein Umrüsten der Beschriftungsvorrichtung erübrigt sich, da ein einfaches Umprogrammieren der Vorrichtung genügt, damit der Schriftzug in gewünschter Weise verändert wird. Dies ist gegenüber dem bekannten Verfahren äußerst zeitsparend. Darüber hinaus bleibt der eingebrannte Schriftzug auch nach dem Abätzen der Kupferschicht erhalten.

Neben dem oben beschriebenen Beschriften der Zwischenschicht des Laminats ist es möglich, mit einer geringeren Intensität nur die Oberfläche der Kupferschicht zu beschriften. Das Kupfer wird dabei durch die Hitzeeinwirkung oxidiert und geschwärzt. Da sich auch hier das Problem stellt, möglichst hohe Intensitäten im Fokus zu erreichen, ist auch in diesem Fall eine Strahlaufweitung und die Intensitätssteuerung durch die Blende unverzichtbar.

Vorzugsweise wird der Laser gepulst betrieben, d.h. es werden Lichtpulse hoher Intensität erzeugt. In diesem Fall läßt sich die durchschnittliche Intensität in Bezug auf ein Zeitintervall durch Steuerung der Pulsfrequenz bestimmen, da die Durchschnittsintensität um so höher ist, je dichter die Pulsfolge ist. Die Steuerung der Pulsfrequenz erfolgt vorzugsweise durch einen akusto-optischen Modulator, der innerhalb des Resonators angeordnet ist. Darüber hinaus ist es möglich, die Intensität in üblicher Weise durch den Lampenstrom des Lasers zu steuern.

In einer bevorzugten Ausführungsform ist die Beschriftungsvorrichtung mit einer Klemmvorrichtung zum Fixeren des zu beschriftenden Bereichs des Werkstücks in der Brennpunktebene versehen. Entscheidend ist hierbei, die zu beschriftende Werkstückoberfläche während des Beschriftungsvorgangs so genau in der Brennebene zu halten, daß die Intensität ausreichend ist und eine scharfe Abbildung erfolgt. In einer bevorzugten Ausführungsform umfaßt die Klemmvorrichtung einen stationären Tisch zur Auflage des Werkstücks bzw. des zu beschriftenden Bereichs und ein rahmenartiges, d. h. mit einem Ausschnitt versehenes Andrückblech, das gegenüber dem Tisch beweglich ist. Die zu beschriftende Fläche des Werkstücks wird auf den Tisch aufgelegt und durch Bewegen des Andrückblechs gegen den Tisch festgeklemmt, so daß das Beschriften durch den Ausschnittsbereich des Andrückblechs hindurch erfolgen kann.

Vorzugsweise dient eine Beschickungsvorrichtung zur Bewegung des Werkstücks in die Beschriftungsposition hinein und zum anschließenden Entfernen des beschrifteten Werkstücks. In einer bevorzugten Ausführungsform handelt es sich dabei um zwei Rollenbahnen, die in einer Ebene angeordnet sind und das Werkstück in zwei senkrecht zueinander stehenden Raumrichtungen transportieren. Vorzugsweise läßt sich in diesem Fall die Beschriftungsposition festlegen, indem die Transportwege der Rollenbahnen jeweils in einer Transportrichtung durch Anschläge begrenzt werden. Das heißt, das Werkstück wird zunächst auf einer Rollenbahn gegen einen ersten Anschlag gefahren, so daß die Beschriftungspositionen in dieser Raumrichtung festgelegt ist, und anschließend durch die zweite Rollenbahn in der dazu senkrechten Raumrichtung gegen einen zweiten Anschlag gefahren. Die Beschriftungsposition ist in der Bewegungsebene somit eindeutig festgelegt.

Ein Verfahren zum Beschriften von kupferkaschierten Laminaten durch die Vorrichtung gemäß Anspruch 1 ergibt sich aus Anspruch 9. Vorteilhafte Ausgestaltungen dieses Verfahrens ergeben sich aus den Unteransprüchen 10 bis 13.

Im folgenden wird ein bevorzugtes Ausführungsbeispiel anhand der Zeichnung näher erläutert.
Fig. 1 zeigt eine schematische Darstellung der optischen Komponenten einer erfindungsgemäßen Beschriftungsvorrichtung;
Fig. 2 zeigt eine schematische Seitenansicht einer Beschriftungsvorrichtung mit den Komponenten aus Fig. 1;
Fig. 3 zeigt eine Vorderansicht der Beschriftungsvorrichtung aus Fig. 2;
Fig. 4 ist ein Schema zur Erläuterung der Funktionsweise der Beschikkungsvorrichtung; und
Fig. 5 und 6 sind Schnitte durch ein zu beschriftendes Werkstück, die die Funktionsweise der erfindungsgemäßen Beschriftungsvorrichtung zeigen.

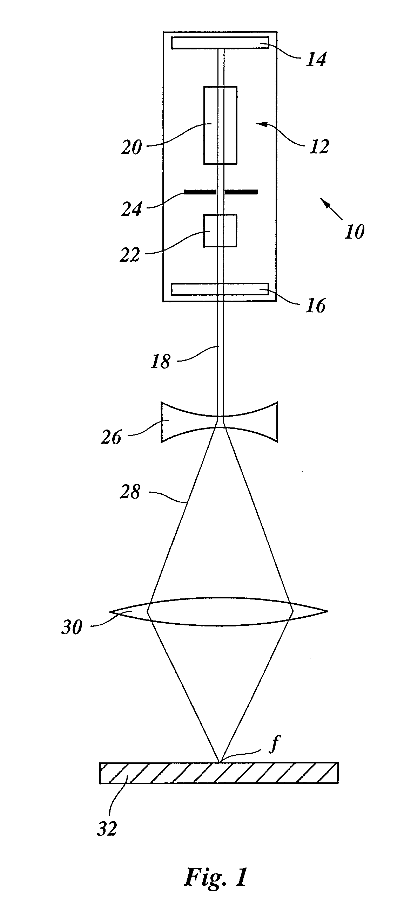

Fig. 1 illustriert den optischen Aufbau der erfindungsgemäßen Vorrichtung zur Beschriftung von kupferkaschierten Laminaten. Ein Laser 10 umfaßt einen Resonator 12 mit einem vollständig reflektierenden Spiegel 14 und einem teilweise durchlässigen Spiegel 16, aus dem der im Resonator 12 erzeugte Laserstrahl 18 austreten kann. Im Inneren des Resonators 12 befindet sich das aktive Medium 20, in diesem Fall ein Nd:YAG-Kristall, das auf nicht näher gezeigte Weise zum Laserprozeß angeregt wird, beispielsweise durch Blitzlampen. Ferner umfaßt der Resonator 12 einen akusto-optischen Modulator 22, durch welchen ein Pulsbetrieb des Lasers 10 ermöglicht wird. Zwischen dem aktiven Medium 20 und dem akusto-optischen Modulator 22 befindet sich eine Blende 24, durch die ein Teil der zwischen den Spiegeln 14,16 reflektierten Intensität abgeblendet werden kann. Somit läßt sich die Intensität des Laserstrahls 18 steuern, indem die Öffnung der Blende 24 vergrößert oder verkleinert wird. Darüber hinaus ist es auch möglich, die Intensität durch Steuern der Pulsfrequenz des akusto-optischen Modulators 22 oder in bekannter Weise durch Veränderung des Lampenstroms der Blitzlampen zu steuern.

Der aus dem Laser 10 austretende Laserstrahl 18 ist auf eine Streulinse 26 gerichtet, durch die der Strahl 18 aufgeweitet wird. Der aufgeweitete Strahlkegel 28 trifft auf eine Sammellinse 30, die den Laserstrahl in einem Brennpunkt f auf der Oberfläche des schematisch dargestellten Werkstücks 32 fokussiert.

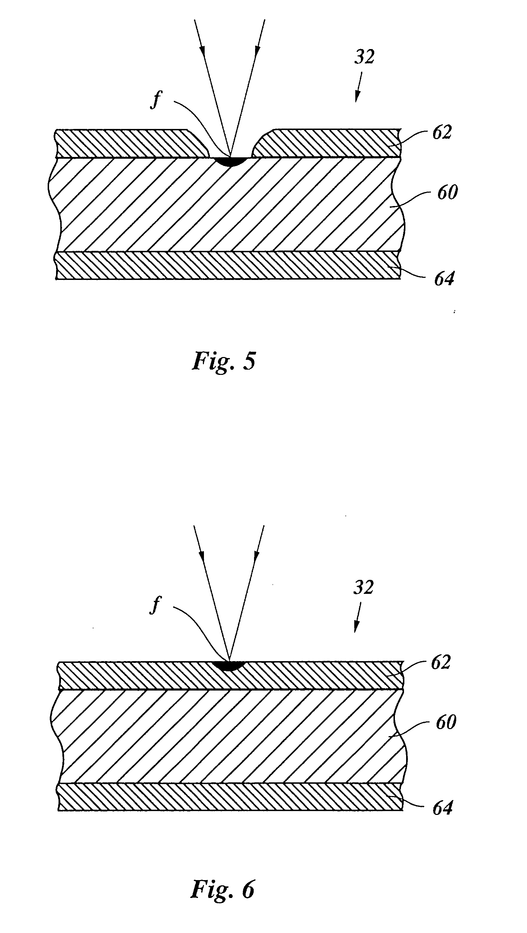

Die Streulinse 26 und die Sammellinse 30 bilden im Prinzip ein Teleskop. Durch das Aufweiten und anschließende Fokussieren des Strahls 18 durch das Teleskop läßt sich ein sehr kleiner Fokus f erreichen, so daß die Flächenintensität auf der Oberfläche des Werkstücks 32 sehr hoch wird. Beispielsweise führt eine Aufweitung etwa um den Faktor 6 bei einer Brennweite der Sammellinse 30 von 240 mm zu einem Fokusdurchmesser von weniger als 50 µm. Durch derart hohe Intensitäten läßt sich eine Beschriftung von kupferkaschierten Laminaten nach den Prinzipien durchführen, wie sie im Zusammenhang mit den Figuren 5 und 6 weiter unten erläutert werden.

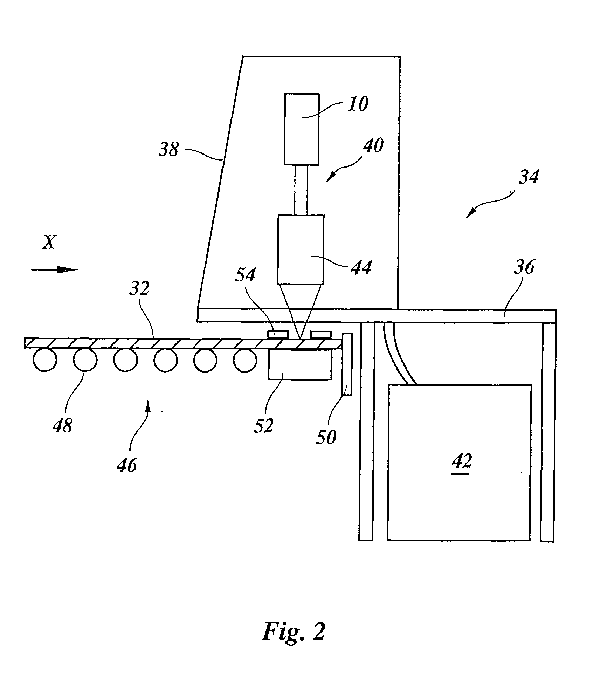

Die Vorrichtung in Fig. 2 umfaßt ein Laserbeschriftungsgerät 34, mit einem auf einem Maschinengestell 36 innerhalb einer Schutzkabine 38 montierten Laserkopf 40 und einer Versorgungseinheit 42, die insbesondere eine Spannungs- und eine Kühlwasserversorgung für den Laserkopf 40 beinhaltet.

Der schematisch dargestellte Laserkopf 40 umfaßt die in Fig. 1 dargestellte Anordnung, nämlich den Laser 10 und das Teleskop 44 mit den beiden Linsen 26,30. Falls die Anordnung es erfordert, kann der Laserkopf 40 weitere optische Komponenten wie Spiegel oder dergleichen umfassen.

Die Beschriftungsvorrichtung aus Fig. 2 umfaßt ferner eine Beschickungsvorrichtung 46, die in Fig. 2 nur teilweise dargestellt ist und eine Rollenbahn 48 umfaßt, auf der ein zu transportierendes Werkstück 32 flach aufliegt. Durch die Rollenbahn 48 läßt sich das Werkstück 32 in der durch einen Pfeil X gekennzeichneten Richtung befördern, bis der vorauslaufende Rand des Werkstücks 32 gegen einen Anschlag 50 stößt. Auf diese Weise wird die Beschriftungsposition des Werkstücks 32 in einer Raumrichtung X festgelegt.

In der Beschriftungsposition liegt der in Fig. 2 rechte Randbereich des Werkstücks 32 in dem Zwischenraum zwischen einem unterhalb des Laserkopfes 40 angeordneten stationären Tisch 52 und einem im Abstand darüber angeordneten Andrückblech 54. Das Andrückblech 54 ist rahmenförmig, d. h. es weist in seiner Mitte einen Ausschnitt auf, durch den ein Beschriftungsfeld festgelegt wird. Üblich sind beispielsweise rechteckige Beschriftungsfelder mit den Maßen 160 mm x 160 mm.

Durch eine vertikale Bewegung des Andrückblechs 54 gegen den Tisch 52, die beispielsweise durch einen pneumatischen Antrieb erfolgen kann, wird das Werkstück 32 zwischen dem Tisch 52 und dem Andrückblech 54 festgeklemmt, und zwar auf solche Weise, daß die Oberfläche des Werkstücks 32 in der Brennpunktebene des Teleskops 44 liegt. Auf diese Weise wird der Strahl 18 des Lasers 10 durch die Öffnung im Andrückblech 54 hindurch auf die Oberfläche des Werkstücks 32 fokussiert, wie es bereits im Zusammenhang mit Fig. 1 erläutert wurde. Da zum Beschriften die Lage des Brennpunktes f auf der Oberfläche verändert werden muß, ist der Laserkopf 40 in der horizontalen Ebene auf nicht gezeigte Weise bewegbar. Besonders vorteilhaft ist es, einen Teil der optischen Komponenten des Laserkopfes 40 zu einer Scannereinheit zusammenzufassen und ausschließlich die Scannereinheit zu bewegen, so daß insbesondere der Laser 10 stationär bleibt.

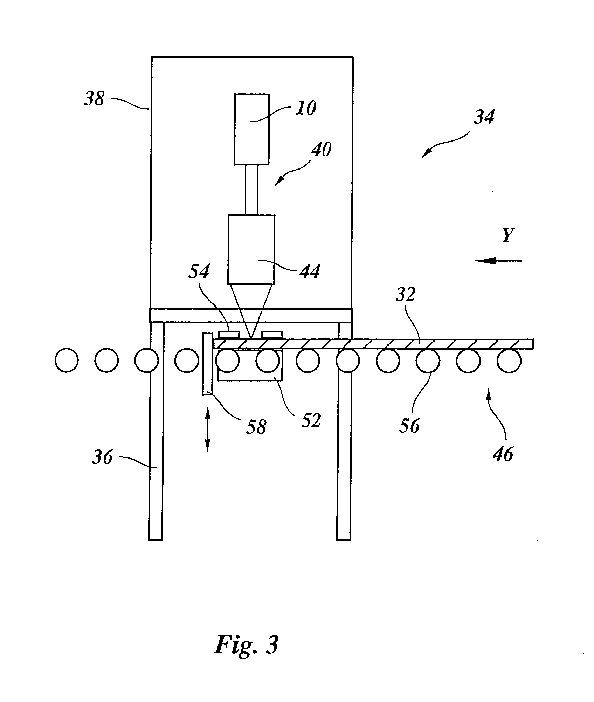

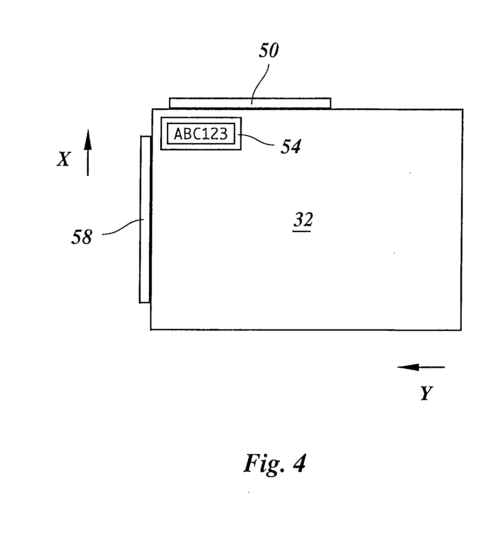

Die Ansicht aus Fig. 3 zeigt weitere Komponenten der Beschickungsvorrichtung 46, nämlich eine weitere Rollenbahn 56, die senkrecht zu der in Fig. 2 gezeigten Rollenbahn 48 verläuft und zum Transport des Werkstücks 32 in der zur Richtung X senkrechten Richtung Y dient. Auch in dieser Raumrichtung Y stößt das Werkstück 32 gegen einen vertikal beweglichen Anschlag 58, durch welchen die Beschriftungsposition in dieser Richtung Y festgelegt wird. Das Beschicken geschieht gemäß Fig. 4 auf folgende Weise: Zunächst wird das Werkstück 32 über die in Fig. 3 gezeigte Rollenbahn 56 bis zum Anschlag 58 unter den Laserkopf 40 transportiert. Anschließend wird es in der dazu senkrechten Richtung X durch die zweite Rollenbahn 48 aus Fig. 2 gegen den Anschlag 50 gefahren. Damit hat es seine Beschriftungsposition erreicht, in welcher der zu beschriftende Bereich durch den Tisch 52 und das Andrückblech 54 festgeklemmt wird und durch Fokussieren des Laserstrahls 18 und Bewegen des Laserkopfes 40 die Beschriftung durchgeführt wird. Nach dem Beschriften gibt das Andrückblech 54 durch Anheben das Werkstück 32 wieder frei, der Anschlag 58 wird nach unten bewegt, und das Werkstück 32 kann in der Richtung Y aus der Beschriftungsvorrichtung heraus transportiert werden. Danach kann der Arbeitszyklus mit einem weiteren Werkstück aufs Neue durchgeführt werden.

Fig. 5 erläutert das Funktionsprinzip des erfindungsgemäßen Beschriftungsverfahrens. Der Schnitt durch das Werkstück 32 zeigt eine Zwischenschicht 60 aus Epoxidharz, die als Substrat für zwei Kupferschichten 62,64 dient, welche die Oberflächen des Werkstücks 32 bilden. Durch Fokussieren des Strahlkegels 28 durch die Linse 30 wird die Kupferoberfläche 62 stark erhitzt, so daß das Kupfer verdampft bzw. oxidiert und durch den eigenen Dampfdruck entfernt wird. Auf diese Weise wird die Oberfläche des Substrats 60 freigelegt. Diese wird ebenfalls erhitzt, so daß eine chemische Reaktion stattfindet und schwarze KohlenstoffVerbindungen an der Oberfläche erzeugt werden. Durch diese Schwärzung wird die Beschriftung der Zwischenschicht 60 erreicht. Falls in einem nachfolgenden Verarbeitungsschritt die Kupferschichten 62,64 vom Substrat entfernt werden, bleibt die Beschriftung auf der Zwischenschicht 60 erhalten.

Fig. 6 zeigt den Beschriftungsvorgang mit schwächeren Laserintensitäten. In diesem Fall ist die Intensität nicht ausreichend, um die Kupferschicht 62 zu verdampfen, sondern es findet lediglich eine Oxidation der Kupferoberfläche statt, die ebenfalls zu einer Schwärzung führt.

## Patentansprüche

1. Vorrichtung zur Beschriftung von kupferkaschierten Laminaten, **gekennzeichnet durch** einen Laser (10), in dessen Resonator (12) eine Blende (24) zur Intensitätssteuerung angeordnet ist, eine Aufweitungsoptik (26) zum Aufweiten des Laserstrahls (18) und eine Fokussierungsoptik (30) zum Fokussieren des aufgeweiteten Laserstrahls (28) auf der Oberfläche eines Werkstücks (32) aus kupferkaschiertem Laminat.

2. Vorrichtung gemäß Anspruch 1, **dadurch gekennzeichnet, daß** der Laser (10) zum Pulsbetrieb vorgesehen ist.

3. Vorrichtung gemäß Anspruch 2, **dadurch gekennzeichnet, daß** innerhalb des Resonators (12) ein akusto-optischer Modulator (22) zum Pulsen des Lasers (10) angeordnet ist.

4. Vorrichtung gemäß einem der vorhergehenden Ansprüche, **gekennzeichnet durch** eine Klemmvorrichtung (52,54) zum Fixieren des Werkstücks (32) in der Brennpunktebene der Fokussierungsoptik (30).

5. Vorrichtung gemäß Anspruch 4, **dadurch gekennzeichnet, daß** die Klemmvorrichtung (52,54) einen stationären Tisch (52) zur Auflage des Werkstücks (32) und ein rahmenartiges, gegenüber dem Tisch (52) bewegliches Andrückblech (54) umfaßt.

6. Vorrichtung gemäß einem der vorhergehenden Ansprüche, **gekennzeichnet durch** eine Beschickungsvorrichtung (46) zur Bewegung des Werkstücks (32) in die Beschriftungsposition und zum Entfernen des beschrifteten Werkstücks (32).

7. Vorrichtung gemäß Anspruch 6, **dadurch gekennzeichnet, daß** die Beschickungsvorrichtung (46) zwei Rollenbahnen (48,56) zum Transport des Werkstücks (32) in zwei senkrecht zueinander stehende Raumrichtungen (X,Y) umfaßt.

8. Vorrichtung gemäß Anspruch 7, **dadurch gekennzeichnet, daß** zur Festlegung der Beschriftungsposition die Transportwege der Rollenbahnen (48,56) durch Anschläge (50,58) begrenzt werden.

9. Verfahren zum Beschriften von kupferkaschierten Laminaten, **dadurch gekennzeichnet, daß** ein Laserstrahl (18) aufgeweitet und der aufgeweitete Laserstrahl (28) auf die Oberfläche eines Werkstücks (32) aus kupferkaschiertem Laminat fokussiert wird, wobei die Laserintensität innerhalb des Laserresonators (12) durch eine Blende (24) gesteuert wird.

10. Verfahren gemäß Anspruch 9, **dadurch gekennzeichnet, daß** der Laserstrahl (18) gepulst wird.

11. Verfahren gemäß Anspruch 9 oder 10, **dadurch gekennzeichnet, daß** das Werkstück (32) vor dem Beschriften durch eine Beschickungsvorrichtung (46) in eine Beschriftungsposition gebracht wird und nach dem Beschriften aus dieser entfernt wird.

12. Verfahren gemäß Anspruch 11, **dadurch gekennzeichnet, daß** das Werkstück (32) vor dem Beschriften auf einer ersten Rollenbahn (56) in einer ersten Raumrichtung (Y) bis zu einem ersten Anschlag (58) bewegt wird, anschließend auf einer zweiten Rollenbahn (48) in einer dazu senkrechten zweiten Raumrichtung (X) bis zu einem zweiten Anschlag (50) bewegt wird, in dieser Position beschriftet wird und in der ersten Raumrichtung (Y) aus der Beschriftungsposition heraus entfernt wird.

13. Verfahren gemäß einem der Ansprüche 9 bis 12, **dadurch gekennzeichnet, daß** das Werkstück (32) während des Beschriftungsvorgangs in der Beschriftungsposition fixiert wird.
